# EUROPEAN PATENT APPLICATION

(11) **EP 3 147 929 A1**
(43) Date of publication of application: **29.03.2017**
(21) Application number: 15186664.7
(22) Date of filing: 24.09.2015
(51) Int. Cl.: H01J 37/244, H01J 37/26

(54) **CHARGED PARTICLE MICROSCOPE WITH IMPROVED SPECTROSCOPIC FUNCTIONALITY**

(71) Applicant: FEI Company, Hillsboro, OR 97124-5793 (US); UChicago Argonne, LLC, Chicago, IL 60637 (US)
(72) Inventor: Dona, Pleun, 5504 KN Veldhoven (NL); Mohammadi-Gheidari, Ali, 5684 GA Best (NL); van Veen, Gerard, 5581 HB Waalre (NL); Zaluzec, Nestor J., Bolingbrook, IL Illinois 60440 (US)
(74) Representative: Bakker, Hendrik

(57) **Abstract**

A charged-particle microscope, comprising:
- A source, for producing a beam of charged particles that propagate along a particle-optical axis;
- A specimen holder, for holding a specimen on a sample plane S' extending perpendicular to said particle-optical axis;
- An illuminator, for directing said beam so as to irradiate the specimen;
- An imaging system, for receiving a flux of charged particles transmitted through the specimen and directing it onto a sensor;
- A detector arrangement D, for detecting a flux of X-rays emanating from the specimen in response to said irradiation, said detector arrangement comprising a group of discrete sub-detectors D' arranged along mutually different measurement directions relative to the specimen holder,

whereby:
- A first pole piece 60 is located proximal a first side of the sample plane, being an extremal pole piece of said illuminator;
- A second pole piece 80 is located proximal a second side of the sample plane, being an extremal pole piece of said imaging system;
- Each of said pole pieces has substantially the form of a truncated cone, which tapers toward the sample plane and terminates in a respective truncation surface 63,83,

wherein the group of sub-detectors D' is mobile, and can be:
- Deployed into a measurement configuration, for the purpose of detecting said X-ray flux;
- Retracted into a stowed configuration, when not being used to detect said X-ray flux;

whereby, in said measurement configuration:
- A first sub-group of said sub-detectors is located at said first side of the sample plane, outside a first perimeter formed by perpendicular projection of said first truncation surface 63 onto the sample plane;
- A second sub-group of said sub-detectors is located at said second side of the sample plane, outside a second perimeter formed by perpendicular projection of said second truncation surface 83 onto the sample plane.

## Description

This invention was made under CRADA No. 1300701 between FEI Company and UChicago Argonne, LLC, as Operator of Argonne National Laboratory, operated for the United States Department of Energy. The U.S. Government has certain rights in this invention.

The invention relates to a charged-particle microscope (CPM), comprising:
- A source, for producing a beam of charged particles that propagate along a particle-optical axis;
- A specimen holder, for holding a specimen on a sample plane extending perpendicular to said particle-optical axis;
- An illuminator, for directing said beam so as to irradiate the specimen;
- An imaging system, for receiving a flux of charged particles transmitted through the specimen and directing it onto a sensor;
- A detector arrangement, for detecting a flux of X-rays emanating from the specimen in response to said irradiation, said detector arrangement comprising a group of discrete sub-detectors arranged along mutually different measurement directions relative to the specimen holder,
whereby:
- A first pole piece is located proximal a first side of the sample plane, being an extremal pole piece of said illuminator;
- A second pole piece is located proximal a second side of the sample plane, being an extremal pole piece of said imaging system;
- Each of said pole pieces has substantially the form of a truncated cone, which tapers toward the sample plane and terminates in a respective truncation surface.

The invention correspondingly relates to a method of detecting X-rays in such a microscope.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a specimen by a scanning electron beam precipitates/stimulates emanation of "auxiliary" radiation from the specimen, in the form of secondary electrons, backscattered electrons, X-rays and photoluminescence (infrared, visible and/or ultraviolet photons), for example; one or more components of this emanating radiation is/are then detected and used for image accumulation purposes, spectroscopy, etc.
- In a TEM, the electron beam used to irradiate the specimen is chosen to be of a high-enough energy to pass through the specimen (which, to this end, will generally be thinner than in the case of a SEM specimen); the flux of transmitted electrons emanating from the specimen can then be used to create an image, spectrum, diffractogram, etc. When such a TEM is operated in scanning mode (thus becoming a STEM), an image can be accumulated during a scanning motion of the irradiating electron beam.
- Recent years have seen the development of the so-called Scanning Confocal Electron Microscope (SCEM), which can be regarded as an electron-based analogy to optical confocal microscopy. For the (scope) purposes of the current document, a SCEM can be regarded as being a variant of the basic architecture / operating principle of a STEM.

More information on some of the topics elucidated here can, for example, be gleaned from the following Wikipedia links:
http://en.wikipedia.org/wiki/Electron microscope
http://en.wikipedia.org/wiki/Scanning electron microscope
http://en.wikipedia.org/wiki/Transmission electron microscopy
http://en.wikipedia.org/wiki/Scanning transmission electron microscopy
http://en.wikipedia.org/wiki/Scanning confocal electron microscopy

As an alternative to the use of electrons as irradiating beam, charged particle microscopy can also be performed using other species of charged particle. In this respect, the phrase "charged particle" should be broadly interpreted as encompassing electrons, positive ions (e.g. Ga or He ions), negative ions, protons and positrons, for instance. As regards ion-based microscopy, some further information can, for example, be gleaned from sources such as the following:
- http://en.wikipedia.org/wiki/Scanning Helium Ion Microscope
- W.H. Escovitz, T.R. Fox and R. Levi-Setti, Scanning Transmission Ion Microscope with a Field Ion Source, Proc. Nat. Acad. Sci. USA 72(5), pp. 1826-1828 (1975).
- http://www.innovationmagazine.com/innovation/volumes/v7n1/coverstory3.shtml

A particular application of a charged-particle microscope is in performing X-ray spectroscopy. An example of such spectroscopy is Energy-Dispersive X-ray Spectroscopy, which is often referred to using the acronyms EDX or EDS. In this technique, a specimen (*e.g.* a mineralogical or semiconductor sample) is bombarded with a focused input beam of electrons, e.g. in a SEM or (S)TEM (or SCEM). A lower-shell electron in an atom of the specimen can be ejected from its orbit by a collision with one of these bombarding electrons, creating an electron hole that is promptly filled by the de-excitation of a higher-shell electron in the atom in question, with the concurrent release of a quantum of energy in the form of an X-ray photon. The energy signature/distribution of photons emitted in this way will be characteristic of the particular electron shell structure of the atom in question, and can thus be used as a "fingerprint" in performing compositional analysis of the specimen. An energy-dispersive spectrometric detector collects, sorts and counts the different photons of different energies, producing a measured spectrum for the location of the specimen onto which the focused input beam was directed; such a spectrum can be rendered as a graph of counts per channel (ordinate) versus channel number (abscissa), corresponding to intensity versus energy, and generally comprising various peaks - whose energy can be used to identify the generating material (which may be an element, chemical compound or mineral, for example, and which may be amorphous or crystalline in nature, for example) and whose height can (in principle) be used to estimate relative quantity of the generating material. If desired, one can then (automatically) move the specimen and/or the beam so that the beam is directed onto a new location on the specimen, and (automatically) repeat the process described above at said new location. This technique is particularly useful in the field of mineralogy, in which a small specimen may contain many different kinds of minerals; however, its usefulness in fields such as metallurgy, microbiology and semiconductor science is also self-evident. For more information on EDX, reference is made to the following Wikipedia link, for example:
http://en.wikipedia.org/wiki/Energy Dispersive Spectroscopy

As here employed, the term EDX encompasses so-called Wavelength Dispersive X-Ray Spectroscopy (WDX or WDS). This latter technique can be regarded as a particular refinement of EDX in which the X-rays emerging from a specimen are filtered (e.g. with the aid of a particular type of crystal), so that only X-rays of a given wavelength are counted at any given time.

Another such spectroscopic technique is Proton-Induced X-Ray Emission (PIXE), in which the input beam comprises protons. This technique is described in more detail in the following reference, for example:
http://en.wikipedia.org/wiki/PIXE

PIXE can, for example, be performed in a proton microscope.

Some general information relating to X-rays can, for example, be gleaned from the following reference:
http://en.wikipedia.org/wiki/X-ray

In all cases, a CPM will comprise at least the following components:
- A radiation source, such as a Thermal, Schottky or Cold Field electron source, or ion gun.
- An illuminator, which serves to manipulate a "raw" radiation beam from the source and perform upon it certain operations such as focusing, aberration mitigation, cropping (with an aperture), filtering, etc. It will generally comprise one or more (charged-particle) lenses, and may comprise other types of (particle-)optical components also. If desired, the illuminator can be provided with a deflector system that can be invoked to cause its output beam to perform a scanning motion across the specimen being investigated.
- A specimen holder, on which a specimen under investigation can be held and positioned (e.g. tilted, rotated). If desired, this holder can be moved so as to effect scanning motion of the beam w.r.t. the specimen. In general, such a specimen holder will be connected to a positioning system such as a mechanical stage.
- Detection/sensing/imaging apparatus, for detecting radiation emanating from an irradiated specimen. This can take many different forms, depending on the radiation being detected. Examples include photomultipliers (including solid state photomultipliers, SSPMs), photodiodes, CMOS detectors, CCD detectors, photovoltaic cells, etc., which may, for example, be used in conjunction with a scintillator film, for instance. In the specific case of X-ray detection, use is typically made of a so-called Silicon Drift Detector (SDD), Silicon Lithium (Si(Li)) detector, related semiconductor-type detector, or superconducting bolometer/calorimeter, for example: see, for more information:
   http://en.wikipedia.org/wiki/Silicon drift detector
   http://en.wikipedia.org/wiki/X-ray fluorescence#Si.28Li.29 detectors

In the case of a transmission-type CPM (such as a (S)TEM, for example), the apparatus/tool will also comprise:
- An imaging system, which essentially takes charged particles that are transmitted through a specimen (plane) and directs (focuses) them onto a sensor, such as an imaging device, spectroscopic apparatus (*e.g*. an EELS module; EELS = Electron Energy-Loss Spectroscopy), etc. As with the illuminator referred to above, the imaging system may also perform other functions, such as aberration mitigation, cropping, filtering, etc., and it will generally comprise one or more charged-particle lenses and/or other types of particle-optical components.

Both the illuminator and the imaging system will have extremal (terminal/initial) pole pieces that face each other across the abovementioned sample plane. Such pole pieces may be associated with magnetic or electrostatic lens elements. For example:
- In the case of a magnetic lens element, the pole piece can be part of a yoke whose purpose is to guide and concentrate magnetic flux into a confined region of the sample plane. A (S)TEM typically uses such magnetic lenses;
- In the case of an electrostatic lens element, the pole piece can be an outer/final electrode with a small hole around the particle-optical axis where field line emergence occurs.

Such pole pieces conventionally take the form of a (quasi-)truncated cone, which tapers toward the sample plane and which terminates in a truncation surface (*e.g*. a circular disk, domed surface, concave surface, *etc*.) that faces toward the sample plane (and is generally symmetric about the particle-optical axis). In many cases, the last lens element of the illuminator and the first lens element of the imaging system are regarded as collectively forming a so-called "objective lens", inside which the sample plane is located.

In what follows, the invention may - by way of example - sometimes be set forth in the specific context of electron microscopy. However, such simplification is intended solely for clarity/illustrative purposes, and should not be interpreted as limiting.

An example of a CPM as set forth in the opening paragraph above is, for example, known from co-pending European Patent Application EP 14200596 (FNL1425), which has a common applicant with the present invention. Said document describes the use of a distribution/group of individual/discrete X-ray detectors disposed along different angular/measurement directions relative to the specimen, whereby (angularly-resolved) signals from these detectors are used as input to a mathematical procedure that allows improved quantitative spectral analysis of the specimen. The document is chiefly concerned with mathematical details of a particular use of such a group of sub-detectors.

On the other hand, as will transpire from the following discussion, the present invention is more concerned with the constructional / geometrical aspects of such a configuration in which a group of X-ray sub-detectors is used.

The invention provides a CPM as set forth in the opening paragraph above, which is characterized in that the group of sub-detectors is mobile, and can be:
- Deployed into a measurement configuration, for the purpose of detecting said X-ray flux;
- Retracted into a stowed configuration, when not being used to detect said X-ray flux;
whereby, in said measurement configuration:
- A first sub-group of said sub-detectors is located at said first side of the sample plane, outside a first perimeter formed by perpendicular projection of said first truncation surface onto the sample plane;
- A second sub-group of said sub-detectors is located at said second side of the sample plane, outside a second perimeter formed by perpendicular projection of said second truncation surface onto the sample plane.

This inventive set-up achieves a number of important advantages, which can be set forth as follows:
(i) The space around the specimen holder in a CPM, particularly between said (opposed) first and second pole pieces, is generally very cluttered, with very little spare volume. Typically:
   - The illuminator and imaging system of the "primary" particle-optical column (of electrons in the case of a (S)TEM) will each have an extremal pole piece very near the sample plane;
   - There may also be a corresponding pole piece associated with a "secondary" particle-optical column, such as a machining ion beam;
   - There may be one or more conduits for admitting certain gases to the vicinity of the specimen, *e.g*. for purposes of performing *in situ* deposition/etching, or to produce a micro-gaseous environment about the specimen, for instance;
   - The specimen holder itself will need to have a free path to move in and out between a specimen loading/unloading position (distal from the particle-optical axis) and a specimen studying position (on/proximal the particle-optical axis). It will generally also need some room to be able to perform specimen tilt/rotation;
   - One or more manipulators (*e.g.* somewhat similar to wobble sticks) will need radial access to the vicinity of the specimen;
   The present invention addresses this issue by allowing the group of sub-detectors to be retractable, so as to get them out of the specimen vicinity when they're not actually being used. This frees up space, and makes it easier to move items in and out of the volume around the particle-optical axis / sample plane. The sub-detectors need only be deployed when an X-ray detection session is about to commence, and can be stowed (parked) when that session has been completed.
(ii) Making the sub-detectors mobile potentially allows a variety of different deployed/measurement configurations to be achieved, *i.e*. it creates flexibility *vis-à-vis* the positioning of the sub-detectors with respect to a specimen being investigated. This can be of great benefit in studies where angular discrimination / directionality plays an important role, *e.g*. when performing specimen tilt series (so as to acquire a tomographic sinogram), when acquiring a mathematical deconvolution dataset, *etc*.
(iii) Retracting the sub-detectors into a stowed configuration gets them out of the way of potentially damaging radiation (such as secondary/backscattered electrons) and/or environmental factors (such as heat, introduced gases, *etc*.) when specimen studies (such as imaging, diffraction studies, *etc*.) are being performed that do not require X-ray detection.
(iv) Situating clusters (sub-groups) of sub-detectors above and below the specimen will allow optimum collection of (relatively weak, and thus valuable) X-ray flux, covering a larger cumulative solid angle than in the case of detection at just one side of the specimen;
(v) Keeping sub-detectors outside the "exclusion zone" defined by the perimeters ("footprints") associated with perpendicular projection of the pole piece truncation surfaces onto the sample plane preserves the limited space between the sample plane and the pole pieces, leaving enough room for the specimen to be tilted (*e.g*. rolled or pitched) if desired, such as when acquiring a sinogram. This would not be possible if sub-detectors were located between the sample plane and one of the truncation surfaces, *e.g*. as in the case of United States patent US 8,314,386.

Other ways of considering/visualizing/defining the exclusion zone referred to here are, for example, as follows:
- Consider a cylinder "clamped" between said pole pieces, whose bottom is co-perimetric with one of said truncation surfaces and whose top is co-perimetric with the other of said truncation surfaces (both truncation surfaces typically having a substantially circular or oval perimeter). The present invention stipulates that, in said measurement configuration, the various sub-detectors are located outside the cylindrical surface of this cylinder. If the truncation surfaces are of different sizes, then said cylindrical surface becomes a conical surface.
- Alternatively, one can say that the perpendicular distance of all sub-detectors to the particle-optical axis at a given side of the sample plane is greater than the radius of the truncation surface (centered on the particle-optical axis) at that same side of the sample plane.

The skilled artisan will grasp that such descriptions effectively indicate that the sub-detectors are not to be located in the space directly between the opposing pole pieces.

In a particular embodiment of the invention:
- Said sub-detectors are mounted on a shared, forked frame;
- Said frame can be moved as a whole into and out of said measurement configuration.

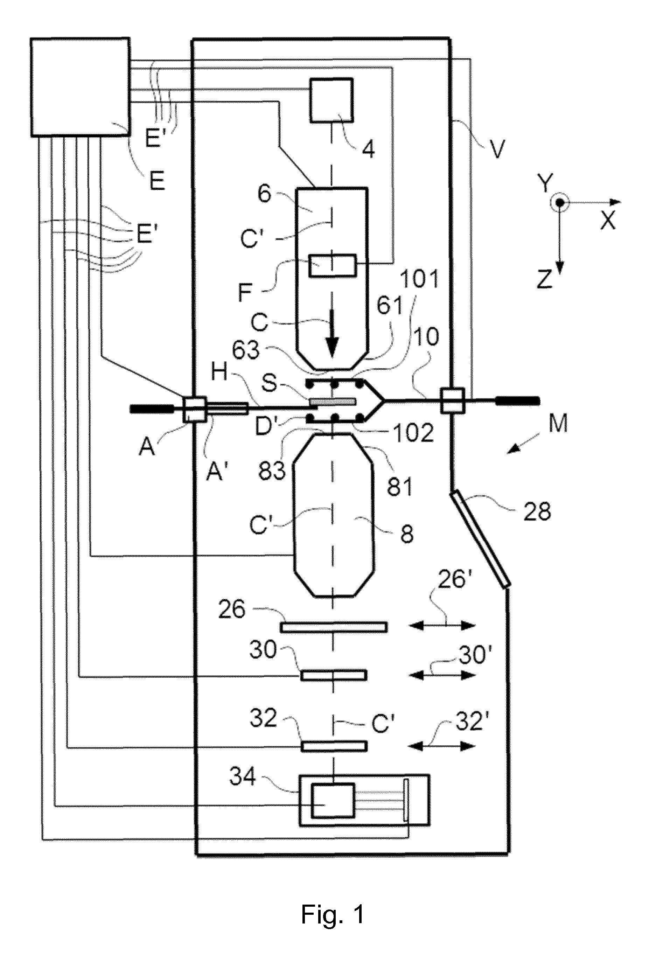

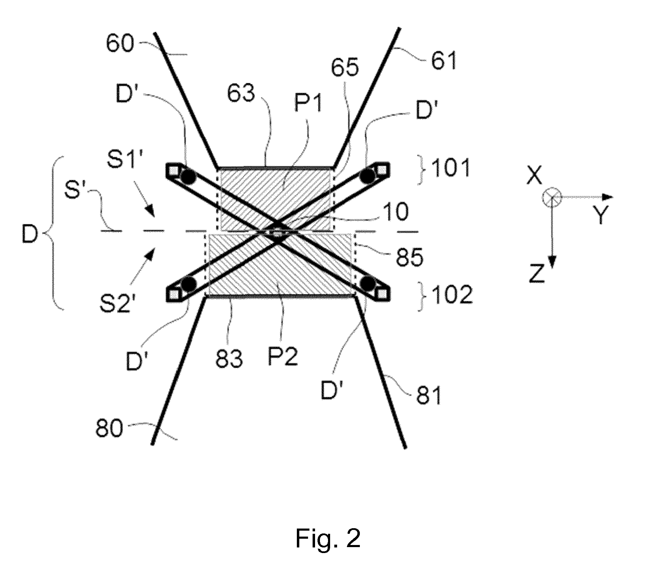

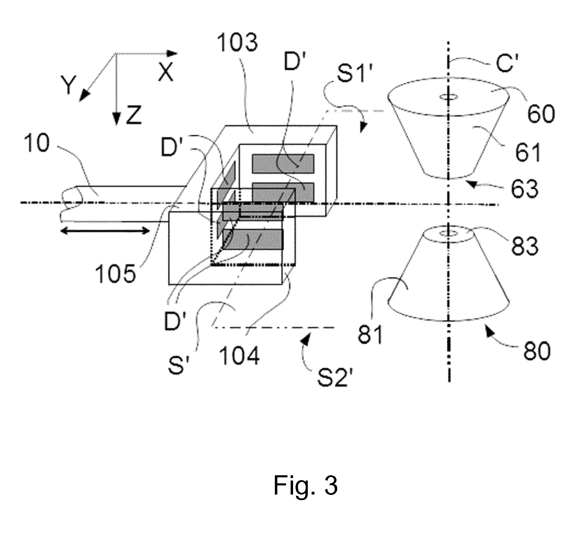

With exemplary reference to a Cartesian coordinate system (X,Y,Z) in which:
- The charged-particle beam propagates along the Z-direction;
- The sample plane corresponds to the XY plane,
such a forked frame can, for example, take the form of a substantially straight rod (*e.g*. a manipulator arm extending along and movable in X) that bifurcates into:
(a) A first branch at the first (upper; -Z) side of the sample plane and a second branch at the second (lower; +Z) side of the sample plane. Each of these first and second branches can itself have a bifurcated form, with two opposing arms that straddle the particle-optical axis (in ±Y) and extend outside said exclusion zone (when moved into position in the measurement configuration). Each of these arms can then have a plurality of sub-detectors mounted thereon, so as to "look at" a nominal specimen position (in the midst of the arms) from different directions. See Figures 1 and 2, for example.
   Or, alternatively:
(b) A "left wall" and a "right wall" that straddle the particle-optical axis (in ±Y) and are sheet-like in form, each having an "upper portion" at the first (-Z) side of the sample plane and a "lower portion" at the second (+Z) side of the sample plane. Each of these portions can then have a plurality of sub-detectors mounted thereon. See Figure 3, for example.

Needless to say, the frame does not necessarily have to be deployable in X, as in the examples above; it could, for example, also be advanced/withdrawn along another radial direction relative to Z, or swung toward/away from the particle-optical axis, for instance.

In another embodiment of the invention:
- Said sub-detectors are mounted on a scaffold structure of variable geometry;
- Said scaffold structure can be endowed with:
   ▪ A first geometry, so as to deploy said sub-detectors; and
   ▪ A second, different geometry, so as to retract said sub-detectors.

An example of such an embodiment comprises a set of hinged arms that can be swung into different positions about the specimen holder. Alternatively, one could employ a concertina-like frame that can fold in upon itself when not in use. In a particular scenario:
- A plurality of support arms is hinged around a perimeter of both of said first and second pole pieces. Each of these arms supports a sub-detector removed/distal from its hinging point.
- In stowed/retracted configuration, these arms rest against/near/toward the conical surfaces of said pole pieces.
- In measurement/deployed configuration, the arms are lowered down toward the sample plane, placing their sub-detectors in a "mini-swarm" about the specimen.

With reference to the embodiments discussed in the previous two paragraphs, one can also conceive various hybrids of these embodiments. One such hybrid uses a forked frame to carry a first subset of sub-detectors, but this frame includes a movable structure (*e.g.* a hinged or sliding arm or wall) to carry a second subset of sub-detectors, whereby said movable structure:
- Has a first posture/position when the frame is being transitioned into or out of its deployment location (measurement configuration); but
- Can be (reversibly) moved (*e.g*. hinged/slid) into a second posture/position when the frame has been brought to rest at its deployment location.

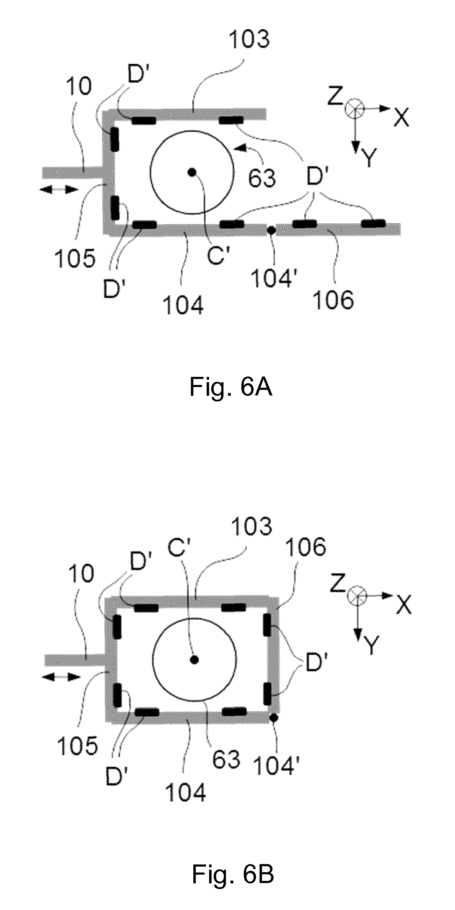

See Figures 6A, 6B, for example. Such an embodiment provides means of observing even more of the X-ray flux (measurement directions) emanating from a specimen, particularly at the "far side" of a specimen opposite the side from which the frame is moved into position. The movable nature of said movable structure allows it to be kept out of the way (first posture/position) of the deployment trajectory of the frame / particle-optical axis until it is actually needed (second posture/position) during an X-ray measurement session.

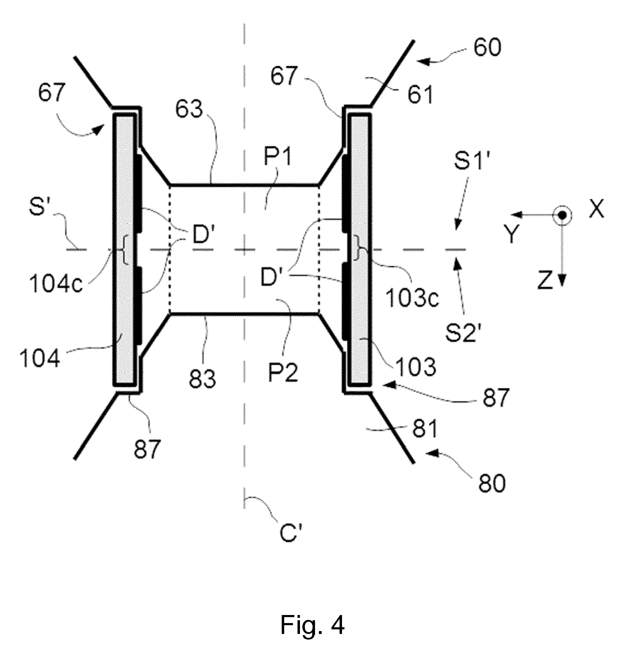

In a particular embodiment of the invention, at least one of said pole pieces comprises a recess into which part of said detector arrangement extends when it is in said measurement configuration. Typically, one would like to deploy the detector arrangement as close as possible to the specimen (so as to increase the cumulative (solid) angle spanned by the various sub-detectors relative to the specimen), and yet keep it outside the abovementioned exclusion zone. To this end, providing a recess / cavity (*e.g*. a groove or furrow) at a suitable location in the (conical) surface of one or both of the first and second pole pieces can allow the (frame / scaffold of the) detector arrangement to be moved closer to the particle-optical axis, by creating some extra "maneuvering space" that would otherwise not be available. In particular, because "non-active" parts of the detector arrangement (such as support structures, detector guard rings, etc.) can be (partially) disposed in said recess, this allows "active" parts of the detector arrangement (*i*.*e*. detection surfaces) to more efficiently span the available X-ray propagation volume around the specimen. Apart from such line-of-sight / acceptance-angle considerations, a recess as set forth here can help in positioning/aligning the detector arrangement into its measurement configuration. If such a recess is relatively small/shallow and properly located (*e.g*. not too near the particle-optical axis), then it will have a minimal effect on the magnetic/electric functioning of the pole piece(s) in question. See Figure 4, for example.

In a further embodiment of the invention, when in said stowed configuration, at least some of said sub-detectors are located in a shadow region at a leeward side of an eclipsing obstruction proximal the sample plane. In other words, when in its retracted location, the detector arrangement is "parked" in a space where some / most / all of its sub-detectors will be shielded by said obstruction from (charged-particle) radiation emanating from an irradiated specimen under (non-X-ray) investigation. The obstruction in question may be a "natural" component of the microscope (*e.g*. a protruding/elongated part of the holder on which the specimen is located), or it may be a dedicated item (such as a plate or block) placed at a strategic location to specifically achieve such shielding. If desired, the obstruction may be cooled (*e.g*. using a water conduit or Peltier element), for instance so as to:
- Help thermally shield a cryogenic specimen;
- Mitigate detector thermal noise.

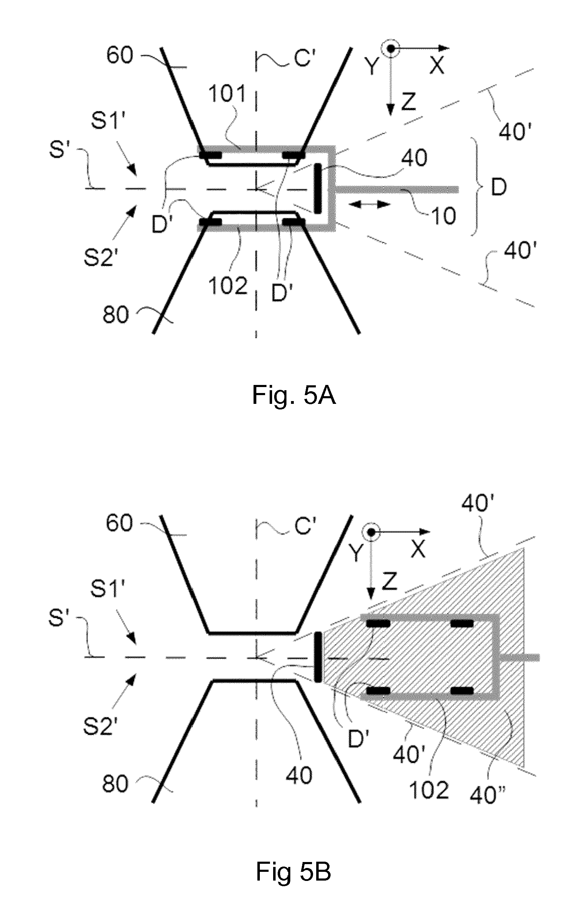

See Figures 5A and 5B, for example.

A shadow region such as that described in the previous paragraph can also be put to good use when the detector arrangement is in its measurement configuration. For example, one can deploy the detector arrangement so that at least part of a non-detecting structure thereof (such as a frame, detector guard ring, *etc*.) is located in said shadow region. This increases measurement efficiency / effective use of available space, since (portions of) "non-active" parts of the detector arrangement are deliberately located outside the X-ray propagation volume around the specimen (as they would serve no useful purpose if they were located within this volume), allowing the "active" parts of the detector arrangement to better span this volume.

It should be noted that the output signals from the various sub-detectors in the inventive detector arrangement can be used in different ways. For example:
- Individual outputs can be considered independently, so as to yield angularly-resolved information ("vector result");
- Outputs can be summed/combined, so as to yield a larger net captured X-ray flux ("scalar result"),
or combinations hereof.

It should also be noted that the fact that the specimen is held *on* the abovementioned sample plane does not require it to be held *in* that plane: in other words, the specimen can be tilted relative to said plane, which will, however, intersect at least part of such a tilted specimen.

For good order, it should further be noted that, although this text may make reference to "a" detector arrangement, the present invention allows a plurality of (different) detector arrangements, if desired. These may be used severally, but may also be used jointly/cooperatively, as required/desired. For example, one could conceive a pair of detector arrangements that are introduced from different directions and that "team up" to form a composite arrangement; specifically, such a scenario could form an alternative to the situation shown in Figure 6B, for example. Alternatively, one could employ a collection of different detector arrangements of different type / size / shape, for instance, and employ these individually according to the specifics of a particular measurement session.

The invention will now be elucidated in more detail on the basis of exemplary embodiments and the accompanying schematic drawings, in which:
Figure 1 renders a cross-sectional elevational view of an embodiment of a transmission-type charged particle microscope in which the present invention can be enacted.
Figure 2 renders a magnified end view of a portion of the subject of Figure 1.
Figure 3 renders a perspective view of part of an alternative embodiment of the present invention.
Figure 4 shows the subject of Figure 3 from another perspective (end view), including a particular modification according to the invention.
Figures 5A and 5B illustrate a particular embodiment of the present invention, on the basis of a magnified, modified portion of Figure 1.
Figures 6A and 6B illustrate a particular embodiment of the present invention, on the basis of modified plan view of the subject of Figure 3.

In the Figures, where pertinent, corresponding parts may be indicated using corresponding reference symbols.

### Embodiment 1

Figure 1 (not to scale) is a highly schematic depiction of an embodiment of a CPM according to the current invention; more specifically, it shows an embodiment of a transmission-type microscope M, which, in this case, is a TEM/STEM(/SCEM) (though, in the context of the current invention, it could just as validly be an ion-based microscope, for example). In the Figure, within a vacuum enclosure V, an electron source 4 (such as a Schottky emitter, for example) produces a beam (C) of electrons that traverse an electron-optical illuminator 6, serving to direct/focus them onto a chosen part of a specimen S (which may, for example, be (locally) thinned/planarized). This illuminator 6 has an electron-optical axis C', and will generally comprise a variety of electrostatic / magnetic lenses, (scan) deflector(s) F, correctors (such as stigmators and/or higher-order aberration correctors), etc.; typically, it can also comprise a condenser system (in fact, the whole of item 6 is sometimes referred to as "a condenser system").

The specimen S is held on a (rod-like) specimen holder H that seats into a cradle A' (such as the FEI CompuStage) connected to a positioning device (stage, actuator) A; this cradle A' can typically be moved/positioned in X,Y, Z, and can also often be rotated about X and/or Y (see the depicted Cartesian coordinate system). Such positioning allows different parts of the specimen S to be irradiated / imaged / inspected by the electron beam traveling along axis C', and also allows the specimen S to be tilted as part of a tomographic measurement series (sinogram acquisition), for example; in principle, it also allows scanning motion to be performed, as an alternative to beam scanning. The holder H holds (at least part of) the specimen S on a specimen plane S' (see Figure 2 also), which, in the current case, may be regarded as being (parallel to) the XY plane.

The (focused) electron beam C traveling along axis C' will interact with the specimen S in such a manner as to cause various types of "stimulated" radiation flux to emanate from the specimen S, including (for example) secondary electrons, backscattered electrons, X-rays and optical radiation (cathodoluminescence). If desired, one or more of these radiation types can be detected, using one or more types of detection device. In the current invention, use is made of a detector arrangement (assembly, collective) D to perform EDX measurements, the detector arrangement D comprising a plurality of sub-detectors D' (such as SDD or Si(Li) detectors, for example) that are angularly distributed about specimen S. This inventive detector arrangement D will be discussed in greater detail below.

In generic use of the microscope M, electrons in beam C can traverse (pass through) the specimen S, emerge (emanate) from it and continue to propagate (substantially, though generally with some deflection/scattering) along axis C'. Such a transmitted electron flux enters an imaging system (combined objective/projection lens) 8, which will generally comprise a variety of electrostatic / magnetic lenses, deflectors, correctors (such as stigmators), etc. In normal (non-scanning) TEM mode, this imaging system 8 can focus the transmitted electron flux onto a fluorescent screen 26, which, if desired, can be retracted/withdrawn (as schematically indicated by arrows 26') so as to get it out of the way of axis C'. An image (or diffractogram) of (part of) the specimen S will be formed by imaging system 8 on screen 26, and this may be viewed through viewing port 28 located in a suitable part of a wall of enclosure V. The retraction mechanism for screen 26 may, for example, be mechanical and/or electrical in nature, and is not depicted here.

As an alternative to viewing an image on screen 26, one can instead make use of the fact that the depth of focus of the electron flux emerging from imaging system 8 is generally quite large (*e.g*. of the order of 1 meter). Consequently, various other types of analysis apparatus can be used downstream of screen 26, such as:
- TEM camera 30. At camera 30, the electron flux can form a static image (or diffractogram) that can be processed by controller E and displayed on a display device (not depicted), such as a flat panel display, for example. When not required, camera 30 can be retracted/withdrawn (as schematically indicated by arrows 30') so as to get it out of the way of axis C'.
- STEM recorder 32. An output from recorder 32 can be recorded as a function of (X,Y) scanning position of the beam C on the specimen S, and an image can be constructed that is a "map" of output from recorder 32 as a function of X,Y. Recorder 32 can comprise a single pixel with a diameter of *e.g.* 20 mm, as opposed to the matrix of pixels characteristically present in camera 30. Moreover, recorder 32 will generally have a much higher acquisition rate (*e.g*. 10⁶ points per second) than camera 30 (*e.g.* 10² images per second). Once again, when not required, recorder 32 can be retracted/withdrawn (as schematically indicated by arrows 32') so as to get it out of the way of axis C' (although such retraction would not be a necessity in the case of a donut-shaped annular dark field recorder 32, for example; in such a recorder, a central hole would allow beam passage when the recorder was not in use).
- As an alternative to imaging using camera 30 or recorder 32, one can also invoke spectroscopic apparatus 34, which could be an EELS module, for example.

It should be noted that the order/position of items 30, 32 and 34 is not strict, and many possible variations are conceivable. For example, spectroscopic apparatus 34 can also be integrated into the imaging system 8.

Note that the controller (computer processor) E (which may have a unitary or composite structure, as desired) is connected to various illustrated components *via* control lines (buses) E'. This controller E can provide a variety of functions, such as synchronizing actions, providing setpoints, processing signals, performing calculations, and displaying messages/information on a display device (not depicted). The skilled artisan will understand that the interior of the enclosure V does not have to be kept at a strict vacuum; for example, in a so-called "Environmental TEM/STEM", a background atmosphere of a given gas is deliberately introduced/maintained within the enclosure V. The skilled artisan will also understand that, in practice, it may be advantageous to confine the volume of enclosure V so that, where possible, it essentially hugs the axis C', taking the form of a small tube (*e.g*. of the order of 1 cm in diameter) through which the employed electron beam passes, but widening out to accommodate structures such as the source 4, specimen holder H, screen 26, camera 30, recorder 32, spectroscopic apparatus 34, *etc*.

The current invention concerns itself with detection of X-rays emanating from specimen S in response to irradiation by beam C. In the context of the invention, it is noted that the extremal/final portion of illuminator 6 just above the specimen plane S' is a (magnetic) pole piece 60 with a (substantially) truncated conical surface 61 that tapers towards sample plane S' and terminates in a truncation surface 63 (refer also to Figure 2). Likewise, the extremal/initial portion of imaging system 8 just below the specimen plane S' is a (magnetic) pole piece 80 with a (substantially) truncated conical surface 81 that tapers towards sample plane S' and terminates in a truncation surface 83. The truncation surfaces 63 and 83 can be perpendicularly projected onto the sample plane S', defining (in the context of the current invention) respective "projection volumes" or "exclusion zones" P1, P2 that are delimited in Figure 2 using broken lines 65 and 85, respectively.

In the embodiment illustrated in Figures 1 and 2, the various sub-detectors D' are mounted on a rod 10, which bifurcates into a first branch 101 and a second branch 102, respectively disposed at a first side S1' and a second side S2' of the sample plane S'. Each of these branches 101, 102 is itself further bifurcated into a pair of arms that oppose one another across the particle-optical axis C' and are located outside the projection lines 65, 85, and thus also outside the exclusion zones P1, P2 (see Figure 2). The frame 10 can be retracted/advanced in the X direction as required; its position in X can also be fine-adjusted so as to deliberately adjust the "lines of sight" (measurement directions) of the sub-detectors D' relative to the Z axis.

The construction described in the previous paragraph corresponds to a forked frame of the type (a) set forth above. However, other scenarios are also possible, and, in this regard, Figure 3 shows a forked frame of the type (b) set forth above. Here, rod/beam 10 bifurcates into a "left wall" 103 and a "right wall" 104 that straddle the particle-optical axis C' (in ±Y). Each of these sheet-like walls 103, 104 extends parallel to X, but also has significant "vertical extent" in the Z-direction, so that each has an "upper portion" at the first side S1' of the sample plane S' (XY plane) and a "lower portion" at the second side S2' of the sample plane S'. Each of these upper and lower portions (on the walls 103, 104, and also correspondingly on a connecting wall ("back wall") 105 to which they are joined) is provided with a plurality of sub-detectors D'. When the arm 10 is advanced along X into its deployed position, these sub-detectors D' face the point of intersection of the particle-optical axis C' and the sample plane S' from various different directions, both above (S1') and below (S2') the sample plane S'. The Y-separation of the walls 103, 104 is such as to keep them outside the exclusion zone referred to above, which, in this case, is (substantially) a cylinder joining truncation surfaces 63, 83 (and co-perimetric therewith). The back wall 105 (and - if present - a front wall 106 as alluded to in Embodiment 4 below) will also be outside said exclusion zone.

### Embodiment 2

Figure 4 shows the subject of Figure 3 from another perspective (end view), but now including a particular modification according to the present invention. The pole pieces 60, 80 comprise respective recesses (cavities, furrows) 67, 87 into which part (*e.g*. walls 103, 104) of the detector arrangement extends when it is in its measurement configuration. As here illustrated, this allows the walls 103, 104 (and possibly also other parts, such as walls 105/106 in Figure 6) to be deployed closer to the particle-optical axis C', while still keeping the sub-detectors D' outside the exclusion zone P1+P2. The recesses 67, 87 can, for example, be circumferential grooves, created by machining (*e.g*. with a lathe or milling tool) or formed during metal casting of the respective pole pieces 60, 80.

### Embodiment 3

Figures 5A and 5B illustrate a particular embodiment of the present invention, on the basis of a magnified, modified portion of Figure 1. In both Figures, a small eclipsing obstruction 40 (*e.g*. a metal plate) is disposed proximal the sample plane S' on one side of the particle-optical axis C'. This obstruction 40 will eclipse/obscure part of a flux of charged particles (*e.g*. secondary / backscattered electrons) emanating from a specimen (not depicted) that is undergoing irradiation; in the Figures, such obscuration is delimited by the broken lines 40', which have their origin at the point of intersection of the particle-optical axis C' with the sample plane S', and which graze the perimeter of obstruction 40. This results in a shadow region 40" (hatched region in Figure 5B) at the leeward side of obstruction 40, *i.e*. the side facing away from the particle-optical axis C'. This shadow region 40" is an ideal location in which to park the retracted detector arrangement D (frame 10/101/102 + sub-detectors D') in their stowed configuration, as shown in Figure 5B, since the obstruction 40 will shield the sub-detectors D' from harmful radiation emanating from a specimen undergoing irradiation at/proximal said origin. When the detector arrangement D is needed for X-ray measurements, it can be moved out of shadow region 40" into its deployed configuration, as shown in Figure 5A.

As depicted in Figures 5A, 5B, obstruction 40 is a dedicated item, but it could just as well be part of specimen holder H, for example (see Figure 1). Even if it is a dedicated item, obstruction 40 can, if desired, be made retractable so as to free up space for the detector arrangement D to be moved into place proximal the specimen.

As set forth above, shadow region 40" can also be put to good use when the detector arrangement D is in its measurement configuration (Figure 5A). For example, one can deploy the detector arrangement D so that at least part of a non-detecting structure thereof (such as a (peripheral/rear) part of branches 101, 102, for instance) remains located in said shadow region 40" while the sub-detectors D' protrude outside it. With reference to Figure 4, one could, for example, leave central regions 103c, 104c of respective walls 103, 104 in such a shadow region, since they serve no detection-related (X-ray flux collection) purpose anyway.

### Embodiment 4

Figures 6A, 6B render a plan view of the subject of Figure 3, but now including a modification according to the current invention. In addition to the fixed walls 103, 104, 105, there is now also a movable wall ("front wall") 106, which is connected to an extremity of wall 104 *via* a hinge 104'. Just like the walls 103, 104, 105, hinged wall 106 is provided with one or more sub-detectors D'. Note that the hinged wall 106:
- Can be kept in a first posture/position (parallel to X) when the rod/frame 10 is being transitioned (moved parallel to X) into or out of its deployment location (in which the arms 103, 104 "embrace" the area below pole piece truncation surface 63) - see Figure 6A; but
- Can be hinged into a second posture/position (parallel to Y) when the rod/frame 10 is at rest at said deployment location, thereby moving wall 106 into a position in which its sub-detectors can "view" a specimen under investigation from a useful set of extra directions - see Figure 6B.

To this end, the hinge 104' can be connected to an actuator (not shown), such as a small electric motor, hydraulic actuator, *etc*. If desired, the wall 106 can be provided with a slit/aperture (not shown) through which a tool (such as a specimen holder, for example) can be inserted into the area under pole piece truncation surface 63.

## Claims

1. A charged-particle microscope, comprising:
- A source, for producing a beam of charged particles that propagate along a particle-optical axis;
- A specimen holder, for holding a specimen on a sample plane extending perpendicular to said particle-optical axis;
- An illuminator, for directing said beam so as to irradiate the specimen;
- An imaging system, for receiving a flux of charged particles transmitted through the specimen and directing it onto a sensor;
- A detector arrangement, for detecting a flux of X-rays emanating from the specimen in response to said irradiation, said detector arrangement comprising a group of discrete sub-detectors arranged along mutually different measurement directions relative to the specimen holder,
whereby:
- A first pole piece is located proximal a first side of the sample plane, being an extremal pole piece of said illuminator;
- A second pole piece is located proximal a second side of the sample plane, being an extremal pole piece of said imaging system;
- Each of said pole pieces has substantially the form of a truncated cone, which tapers toward the sample plane and terminates in a respective truncation surface,
**characterized in that** the group of sub-detectors is mobile, and can be:
- Deployed into a measurement configuration, for the purpose of detecting said X-ray flux;
- Retracted into a stowed configuration, when not being used to detect said X-ray flux;
whereby, in said measurement configuration:
- A first sub-group of said sub-detectors is located at said first side of the sample plane, outside a first perimeter formed by perpendicular projection of said first truncation surface onto the sample plane;
- A second sub-group of said sub-detectors is located at said second side of the sample plane, outside a second perimeter formed by perpendicular projection of said second truncation surface onto the sample plane.

2. A microscope according to claim 1, wherein:
- Said sub-detectors are mounted on a shared, forked frame;
- Said frame can be moved as a whole into and out of said measurement configuration.

3. A microscope according to claim 1, wherein:
- Said sub-detectors are mounted on a scaffold structure of variable geometry;
- Said scaffold structure can be endowed with:
▪ A first geometry, so as to deploy said sub-detectors; and
▪ A second, different geometry, so as to retract said sub-detectors.

4. A microscope according to any of claims 1-3, wherein at least one of said pole pieces comprises a recess into which part of said detector arrangement extends when it is in said measurement configuration.

5. A microscope according to any of claims 1-4, wherein, when in said stowed configuration, at least some of said sub-detectors are located in a shadow region at a leeward side of an eclipsing obstruction proximal the sample plane.

6. A microscope according to any of claims 1-5, wherein, when in said measurement configuration, at least part of a non-detecting structure of said detector arrangement is located in a shadow region at a leeward side of an eclipsing obstruction proximal the sample plane.

7. A method of detecting X-rays in a charged-particle microscope comprising:
- A source, for producing a beam of charged particles that propagate along a particle-optical axis;
- A specimen holder, for holding a specimen on a sample plane extending perpendicular to said particle-optical axis;
- An illuminator, for directing said beam so as to irradiate the specimen;
- An imaging system, for receiving a flux of charged particles transmitted through the specimen and directing it onto a sensor;
- A detector arrangement, for detecting a flux of X-rays emanating from the specimen in response to said irradiation, said detector arrangement comprising a group of discrete sub-detectors arranged along mutually different measurement directions relative to the specimen holder,
in which microscope:
- A first pole piece is located proximal a first side of the sample plane, being an extremal pole piece of said illuminator;
- A second pole piece is located proximal a second side of the sample plane, being an extremal pole piece of said imaging system;
- Each of said pole pieces has substantially the form of a truncated cone, which tapers toward the sample plane and terminates in a respective truncation surface,
which method is **characterized by** the following steps:
- Prior to initiating X-ray detection, moving said group of sub-detectors into a measurement configuration vicinal to said particle-optical axis;
- Using said sub-detectors to detect said X-ray flux;
- When X-ray detection is completed, moving said group of sub-detectors into a stowed configuration distal from said particle-optical axis,
whereby, in said measurement configuration:
- A first sub-group of said sub-detectors is disposed at said first side of the sample plane, outside a first perimeter formed by perpendicular projection of said first truncation surface onto the sample plane;
- A second sub-group of said sub-detectors is disposed at said second side of the sample plane, outside a second perimeter formed by perpendicular projection of said second truncation surface onto the sample plane.
